# EUROPEAN PATENT APPLICATION

(11) **EP 3 099 149 A1**
(43) Date of publication of application: **30.11.2016**
(21) Application number: 14884604.1
(22) Date of filing: 21.05.2014
(51) Int. Cl.: H05K 7/14

(54) **ADJUSTABLE CABINET ASSEMBLY AND CABINET**

(30) Priority: 07.03.2014 CN 201420103671 U
(71) Applicant: ZTE Corporation, Shenzhen, Guangdong 518057 (CN)
(72) Inventor: LI, Jianfeng, Shenzhen Guangdong 518057 (CN)
(74) Representative: Schröer, Gernot H.
(86) International application number: PCT/CN2014/078035
(87) International publication number: WO 2015/131450

(57) **Abstract**

The present invention provides an adjustable cabinet assembly (10) and a cabinet. The adjustable cabinet assembly (10) includes a base (1) having at least one slot, and interface modules (2) mounted, by matching with the slot, on the base (1), wherein the interface module (2) is provided with a mounting surface (21), an interface (22) is arranged on the mounting surface (21), and the lowest point of the mounting surface (21) is higher than the highest point of the slot wall of the slot. The adjustable cabinet includes a cabinet body and further includes an adjustable cabinet assembly (10), wherein the adjustable cabinet assembly (10) is secured to the cabinet body.

## Description

### Technical Field

The present invention relates to the field of communication devices, in particular to an adjustable cabinet assembly and a cabinet which are applicable to multi-interface and multi-angle mounting and usage scenarios.

### Background of the Related Art

Generally, a communication device cabinet consists of a frame body and modules and is mainly applied to a fixed mounting scenario, mounting angles of interfaces are nonadjustable, the module mounting direction of the cabinet is fixed, the cabinet is applicable to a single product design and does not have generality and universality applicable to various products, and the usage scenarios are greatly limited.

A cabinet solution needs to be found, which can satisfy demands of multi-scenario mounting and use, is more flexible in space and configuration and is applicable to usage scenarios of diversified interface directions.

### Summary of the Invention

In order to solve the technical problem existing in the prior art, the embodiments of the present invention provide an adjustable cabinet assembly and a cabinet.

The embodiment of the present invention provides an adjustable cabinet assembly, comprising a base having at least one slot, and interface modules mounted, by matching with the slot, on the base, wherein the interface module is provided with a mounting surface, an interface is arranged on the mounting surface, and a lowest point of the mounting surface is higher than a highest point of a slot wall of the slot.

Preferably, there are a plurality of the slots and each of the slots is provided with interface modules mounted by matching with the slot.

Preferably, there are a plurality of the interface modules mounted by matching with each slot, and inclination angles of mounting surfaces of the plurality of interface modules mounted by matching with each slot are different.

Preferably, the base is rectangular, the plurality of slots are equidistantly distributed on one surface of the base, and width of each of the slots is equal.

Preferably, the interface module is provided with a side wall and a top wall which are mutually perpendicular, the side wall is fit with the slot wall of the slot, and the mounting surface is an inclined surface connected with the side wall and the top wall.

Preferably, a handle for facilitating plugging/pulling is arranged on the top wall of the interface module.

The embodiment of the present invention further provides an adjustable cabinet, comprising a cabinet body and further comprising any one of the above mentioned adjustable cabinet assemblies, wherein the adjustable cabinet assembly is secured to the cabinet body.

According to the adjustable cabinet assembly provided by the embodiment of the present invention, since the interface modules with interface angles being changeable are adopted, the connection of communication devices is enabled to be convenient and quick to perform, the adjustable cabinet provided by the embodiment of the present invention is enabled to have generality and universality, and the demands of multi-interface and multi-angle mounting in different usage scenarios can be satisfied.

### Brief Description of Drawings

FIG. 1 is a structural schematic view of an adjustable cabinet assembly provided by the embodiment of the present invention;
FIG. 2 is an exploded structural schematic view of an adjustable cabinet assembly provided by the embodiment of the present invention;
FIG. 3 is a structural schematic view of an adjustable cabinet provided by the embodiment of the present invention;
FIG. 4 is another structural schematic view of an adjustable cabinet provided by the embodiment of the present invention.

### Preferred Embodiments of the Invention

In order to enable the purpose, technical solution and advantages of the present invention to be clearer, the present invention will be described below in detail in combination with the drawings and the preferred embodiments.

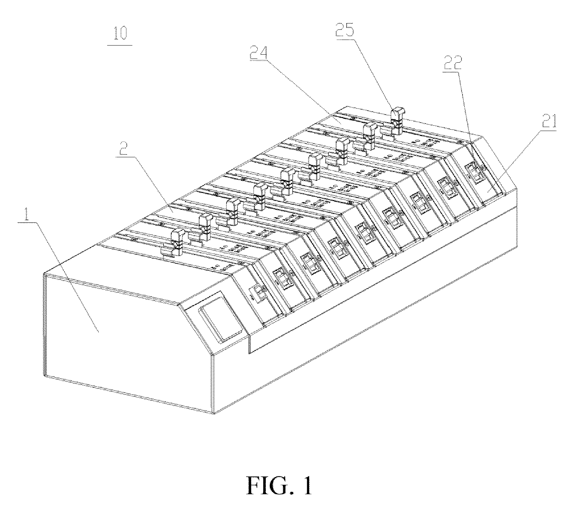

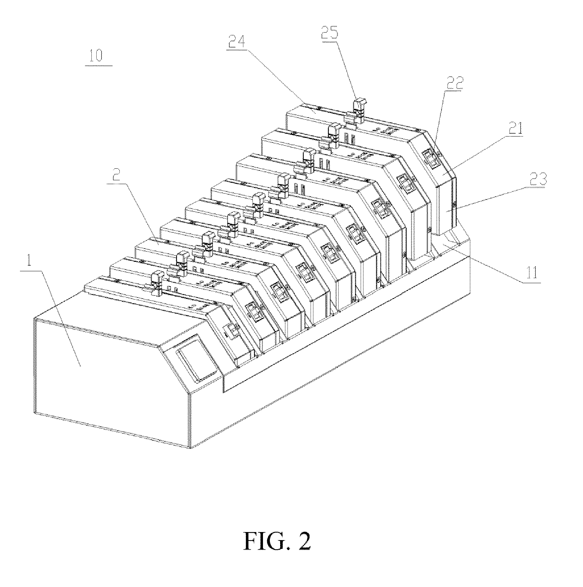

FIG. 1 is a structural schematic view of an adjustable cabinet assembly provided by the embodiment of the present invention. FIG. 2 is an exploded structural schematic view of an adjustable cabinet assembly provided by the embodiment of the present invention. As illustrated in FIG. 1 and FIG. 2, the embodiment of the present invention provides an adjustable cabinet assembly 10, comprising a base 1 and interface modules 2. In this embodiment, the base 1 is rectangular, a plurality of slots 11 are equidistantly distributed on one surface of the base 1, and width of each slot 11 is equal. The interface modules 2 are mounted, by matching with the slots 11, on the base 1, the interface module 2 is provided with an inclined mounting surface 21 and an interface 22 is arranged on the mounting surface 21. The interface module 2 is provided with a side wall 23 and a top wall 24 which are mutually perpendicular, the side wall 23 is fit with the slot wall of the slot 11, the mounting surface 21 is connected with the side wall 23 and the top wall 24, and a handle for facilitating plugging/pulling the interface module in/out of the slot 11 is arranged on the top wall 24. The lowest point of the mounting surface 21 is higher than the highest point of the slot wall of the slot 11 to guarantee that the interface 22 on the mounting surface 21 is exposed outside to allow cable mounting. In this embodiment, each slot 11 of the base 1 is provided with an interface module 2, and the inclination angles of the mounting surfaces 21 of all interface modules 2 are the same.

In order to better adapt to the demands of various multi-interface and multi-angle mounting scenarios, each slot 11 may also be provided with a plurality of interface modules 2 to form an interface module kit. In the interface module kit for using by the same slot 11, the inclination angles of the mounting surfaces 21 of all interface modules 2 may be configured to be different, and according to the demands of mounting scenarios, each slot 11 may be selectively provided with interface modules 2 with inclination angles of mounting surfaces 21 being more matching.

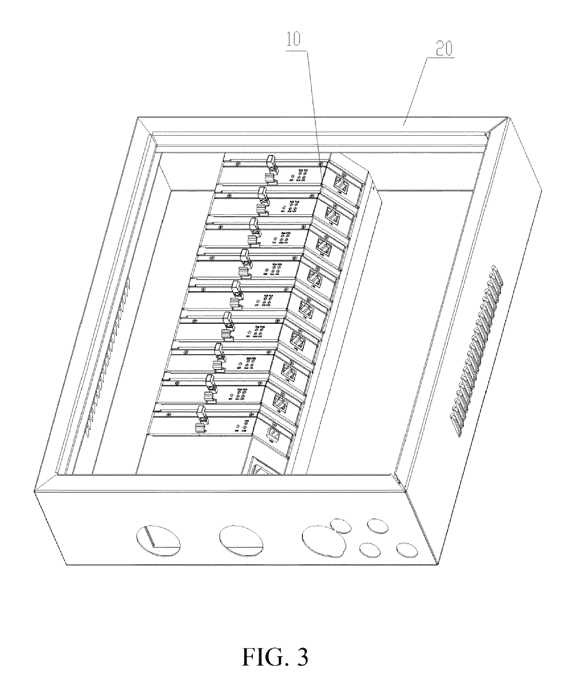

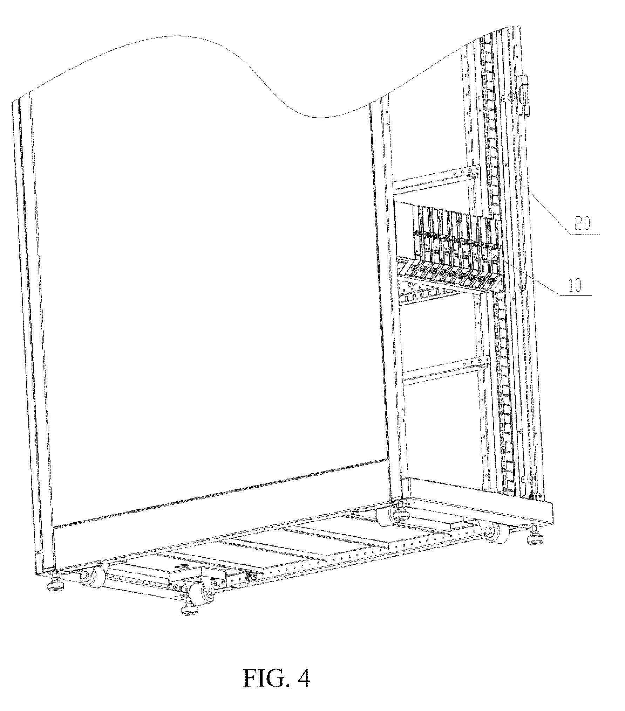

FIG. 3 is a structural schematic view of an adjustable cabinet provided by the embodiment of the present invention. FIG. 4 is another structural schematic view of an adjustable cabinet provided by the embodiment of the present invention. As illustrated in FIG. 3 and FIG. 4, the embodiment of the present invention further provides an adjustable cabinet, comprising an adjustable cabinet assembly 10 and a cabinet body 20, wherein the adjustable cabinet assembly 10 is secured to the cabinet body 20.

During actual use, interface modules 2 with suitable inclination angles can be selected according to demands of mounting environments and mounting angles, and thus the purpose of convenient and quick wiring can be achieved. In addition, interface modules with specific inclination angles can also be prefabricated according to demands of environments to satisfy different demands.

According to the adjustable cabinet assembly and cabinet provided by the embodiment of the present invention, since the interface modules with interface angles being changeable are adopted, the adjustable cabinet provided by the embodiment of the present invention is enabled to have generality and universality, and the demands of multi-interface and multi-angle mounting in different usage scenarios can be satisfied.

The embodiments are just used for describing instead of limiting the technical solution of the present invention. One skilled in the art should understand that modification or equivalent replacement may be made to the technical solution of the present invention without departing from the essence range of the technical solution of the present invention. However, the modification or the equivalent replacement shall be also covered by the range of the claims of the present invention.

## Claims

1. An adjustable cabinet assembly, comprising a base having at least one slot, and interface modules mounted, by matching with the slot, on the base, wherein the interface module is provided with a mounting surface, an interface is arranged on the mounting surface, and a lowest point of the mounting surface is higher than a highest point of a slot wall of the slot.

2. The adjustable cabinet assembly according to claim 1, wherein there are a plurality of the slots and each of the slots is provided with interface modules mounted by matching with the slot.

3. The adjustable cabinet assembly according to claim 2, wherein there are a plurality of the interface modules mounted by matching with each slot, and inclination angles of mounting surfaces of the plurality of interface modules mounted by matching with each slot are different.

4. The adjustable cabinet assembly according to claim 2, wherein the base is rectangular, the plurality of slots are equidistantly distributed on one surface of the base, and width of each of the slots is equal.

5. The adjustable cabinet assembly according to claim 4, wherein the interface module is provided with a side wall and a top wall which are mutually perpendicular, the side wall is fit with the slot wall of the slot, and the mounting surface is an inclined surface connected with the side wall and the top wall.

6. The adjustable cabinet assembly according to claim 5, wherein a handle for facilitating plugging/pulling is arranged on the top wall of the interface module.

7. An adjustable cabinet, comprising a cabinet body and further comprising the adjustable cabinet assembly according to any one of claims 1-6, wherein the adjustable cabinet assembly is secured to the cabinet body.
